# FASCICULE DE BREVET EUROPEEN

(11) **EP 3 900 055 B1**
(45) Date de publication et mention de la délivrance du brevet: **20.11.2024**
(21) Numéro de dépôt: 19848876.9
(22) Date de dépôt: 18.12.2019
(51) Int. Cl.: H01L 33/38, H01L 33/40

(54) **DISPOSITIF OPTOELECTRONIQUE A JONCTION PN**
OPTOELEKTRONISCHE VORRICHTUNG MIT PN-ÜBERGANG
OPTOELECTRONIC DEVICE WITH PN JUNCTION

(30) Priorité: 20.12.2018 FR 1873672
(43) Date de publication de la demande: 27.10.2021
(73) Titulaire: Commissariat à l'Energie Atomique et aux Energies Alternatives, 75015 Paris (FR)
(72) Inventeur: ROTTNER, Jean, 38054 GRENOBLE CEDEX 9 (FR); HAAS, Helge, 38054 GRENOBLE CEDEX 9 (FR)
(74) Mandataire: Cabinet Beaumont
(86) Numéro de dépôt international: PCT/FR2019/053175
(87) Numéro de publication internationale: WO 2020/128340

(56) Documents cités:
- EP-A2- 2 642 533
- US-A1- 2009 184 337
- US-A1- 2016 322 538

## Description

La présente demande de brevet revendique la priorité de la demande de brevet français FR18/73672.

### Domaine technique

La présente description concerne le domaine des dispositifs optoélectroniques à jonction PN tels que des diodes électroluminescentes (LED) ou des photodiodes.

### Technique antérieure

La demande de brevet EP2960951 (DD14957) précédemment déposée par le demandeur décrit des dispositifs optoélectroniques à jonction PN munis d'une grille conductrice isolée revêtant un flanc latéral d'au moins une des régions semiconductrices formant la jonction PN.

L'application d'un potentiel sur la grille conductrice crée un champ électrique permettant d'améliorer l'injection de porteurs de charge dans la jonction, et par conséquent le rendement de conversion du dispositif.

Il serait souhaitable d'améliorer au moins en partie certains aspects des dispositifs optoélectroniques de ce type.

Le document EP 2 642 533 A2 divulgue un dispositif optoélectronique et son procédé de fabrication. Le dispositif comprend un espaceur en contact avec un flanc latéral de l'empilement d'électrode.

Le document US 2016/322538 A1 divulgue un dispositif optoélectronique et son procédé de fabrication. Le dispositif comprend un espaceur métallique en contact avec un flanc latéral de l'empilement d'électrode.

### Résumé de l'invention

Pour cela, un mode de réalisation prévoit un dispositif optoélectronique comportant :
- un empilement vertical d'une première couche semiconductrice dopée d'un premier type de conductivité, d'une deuxième couche semiconductrice dopée du deuxième type de conductivité formant avec la première couche une jonction PN, et d'une troisième couche conductrice disposée sur et en contact avec la face de la deuxième couche opposée à la première couche ;
- une tranchée périphérique traversant les troisième et deuxième couches, ladite tranchée délimitant latéralement une portion de la troisième couche et une portion de la deuxième couche ;
- dans ladite tranchée, un espaceur conducteur en contact avec un flanc latéral de ladite portion de la troisième couche, l'espaceur conducteur (301) étant constitué par une quatrième couche conductrice revêtant uniquement les parois latérales de ladite tranchée (110) ; et
- dans ladite tranchée, une grille conductrice isolée comprenant une couche d'isolant de grille s'étendant sur et en contact avec un flanc latéral de l'espaceur conducteur et sur et en contact avec un flanc latéral de ladite portion de la deuxième couche, et une couche conductrice de grille disposée sur et en contact avec la face de la couche d'isolant de grille opposée à l'espaceur conducteur et à ladite portion de la deuxième couche.

Selon un mode de réalisation, l'espaceur conducteur est en un matériau différent de celui de la troisième couche.

Selon un mode de réalisation, l'espaceur conducteur est en métal.

Selon un mode de réalisation, l'espaceur conducteur est en un métal du groupe comprenant le platine, le nickel et le tungstène.

Selon un mode de réalisation, la troisième couche est en aluminium ou en argent.

Selon un mode de réalisation, le dispositif comprend en outre une métallisation de connexion en contact avec la première couche semiconductrice.

Selon un mode de réalisation, la métallisation de connexion est isolée électriquement de la grille conductrice.

Selon un mode de réalisation, la métallisation de connexion est connectée électriquement à la grille conductrice isolée.

Selon un mode de réalisation, le dispositif comporte en outre une couche semiconductrice émissive entre les première et deuxième couches semiconductrices, la tranchée périphérique traverse la couche semiconductrice émissive, la tranchée délimitant latéralement une portion de la couche semiconductrice émissive, et la grille conductrice isolée s'étendant contre un flanc latéral de ladite portion de la couche semiconductrice émissive.

Selon un mode de réalisation, chacune des première et deuxième couches semiconductrices est en un composé III-N.

Un autre mode de réalisation prévoit un procédé de fabrication d'un dispositif optoélectronique tel que défini ci-dessus, comprenant les étapes successives suivantes :
a) prévoir un empilement comportant les première, deuxième et troisième couches ;
b) former une tranchée périphérique traversant la troisième couche et s'interrompant sur la deuxième couche, ladite tranchée délimitant latéralement ladite portion de la troisième couche ;
c) former dans ladite tranchée un espaceur conducteur en contact avec les flancs de ladite portion de la troisième couche ;
d) prolonger ladite tranchée à travers la deuxième couche, ladite tranchée prolongée délimitant latéralement ladite portion de la deuxième couche ; et
e) former dans ladite tranchée la grille conductrice isolée, dans lequel l'étape c) comprend : - une étape de dépôt d'une quatrième couche conductrice sur la face supérieure de la troisième couche (107) et sur les parois latérales et au fond de ladite tranchée (110) ; puis - une étape de gravure anisotrope verticale de la quatrième couche conductrice, à l'issue de laquelle seules sont conservées les portions verticales de la quatrième couche conductrice revêtant les parois latérales de ladite tranchée (110).

Selon un mode de réalisation, le procédé comprend en outre, après l'étape d) et avant l'étape e), une étape de nettoyage chimique des surfaces exposées de la première couche à l'intérieur de la tranchée.

Selon un mode de réalisation, l'étape de nettoyage chimique est réalisée au moyen d'une solution à base d'hydroxyde de potassium ou d'une solution à base d'hydroxyde de tétraméthylammonium ou d'une solution à base d'hydroxyde de tétraéthylammonium.

### Brève description des dessins

Ces caractéristiques et leurs avantages, ainsi que d'autres, seront exposés en détail dans la description suivante de modes de réalisation particuliers faite à titre non limitatif en relation avec les figures jointes parmi lesquelles :
la figure 1 est une vue en coupe schématique et partielle illustrant un exemple d'un dispositif optoélectronique à jonction PN muni d'une grille conductrice isolée , le dispositif de la figure 1 ne faisant pas partie de l'invention revendiquée ;
la figure 2 est une vue en coupe schématique et partielle illustrant un autre exemple d'un dispositif optoélectronique à jonction PN muni d'une grille conductrice isolée, le dispositif de la figure 2 ne faisant pas partie de l'invention revendiquée ; et
la figure 3 est une vue en coupe schématique et partielle illustrant un exemple d'un dispositif optoélectronique à jonction PN muni d'une grille conductrice isolée selon un mode de réalisation.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés entre eux, cela signifie que ces deux éléments peuvent être connectés ou être reliés ou couplés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures, étant entendu que, en pratique, les dispositifs décrits peuvent être orientés différemment.

Sauf précision contraire, les expressions "environ", "approximativement", "sensiblement", et "de l'ordre de" signifient à 10 % près, de préférence à 5 % près.

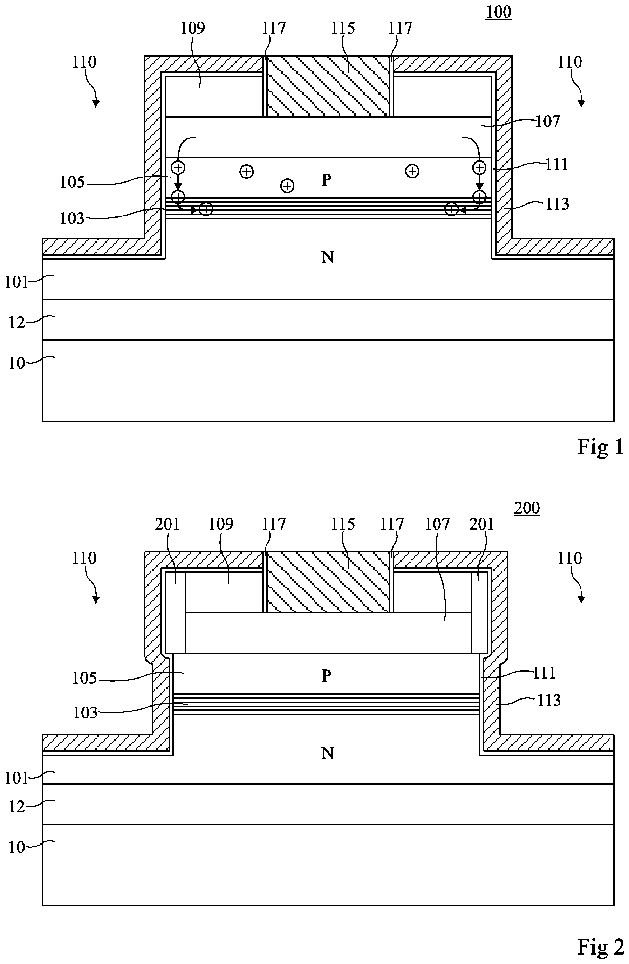

La figure 1 est une vue en coupe schématique et partielle illustrant un exemple d'un dispositif optoélectronique 100 à jonction PN muni d'une grille conductrice isolée.

Le dispositif 100 de la figure 1 est une diode électroluminescente (LED), qui ne fait pas partie de l'invention revendiquée, comprenant un empilement vertical d'une couche semiconductrice de type N 101, d'une couche émissive 103 revêtant la face supérieure de la couche 101, par exemple en contact avec la face supérieure de la couche 101, et d'une couche semiconductrice de type P 105 revêtant la face supérieure de la couche émissive 103, par exemple en contact avec la face supérieure de la couche émissive 103. La jonction PN de la LED est définie par les couches 105 et 101, qui forment respectivement la région d'anode et la région de cathode de la LED. Plus particulièrement, dans cet exemple, la jonction PN de la LED est une jonction de type P-i-N en considérant la couche émissive intermédiaire 103 séparant la couche de type P 105 de la couche de type N 101.

Chacune des couches semiconductrices 101 et 105 peut être en un composé III-N, par exemple en le même composé III-N dopé respectivement de type N pour la couche 101 et de type P pour la couche 105. On entend ici par composé III-N un matériau semiconducteur composite comprenant de l'azote (N), associé à un ou plusieurs éléments de la colonne III du tableau périodique des éléments, par exemple du gallium (Ga), de l'aluminium (Al) et/ou de l'indium (In). A titre d'exemple, on entend ici par composé III-N un matériau semiconducteur du groupe comprenant le nitrure de gallium(GaN), le nitrure d'indium-gallium (InGaN), le nitrure d'aluminium (AlN), le nitrure d'aluminium-gallium (AlGaN) et le nitrure d'indium-gallium-aluminium (InGaAlN). A titre d'exemple, les couches 101 et 105 sont en AlGaN.

La couche émissive 103 peut comprendre des moyens de confinement correspondant à des puits quantiques multiples. A titre d'exemple, la couche 103 comprend une alternance de couches semiconductrices d'un premier composé III-N et de couches semiconductrices d'un deuxième composé III-N, chaque couche du premier composé définissant un puits quantique et étant prise en sandwich entre deux couches du deuxième composé, le premier composé ayant une bande interdite différente de celle du deuxième composé.

Dans l'exemple représenté, les couches 101, 103 et 105 reposent sur un substrat de support 10, par exemple en saphir, une couche tampon 12 faisant interface entre le substrat de support 10 et la face inférieure de la couche 101. La couche tampon 12 et les couches 101, 103 et 105 sont par exemple successivement formées par épitaxie à partir de la face supérieure du substrat 10.

Dans cet exemple, la partie active de la LED 100 est délimitée latéralement par une tranchée périphérique 110 s'étendant verticalement depuis la face supérieure de la couche 105 jusqu'à la couche 101. Dans l'exemple représenté, la tranchée 110 s'étend verticalement jusqu'à un niveau intermédiaire dans la couche 101. A titre de variante, la tranchée 110 s'interrompt sur la face supérieure de la couche 101. Ainsi, la partie active de la LED 100 forme, dans l'empilement des couches 105, 103, et éventuellement 101, un îlot ou mesa en forme de plot délimité latéralement par la tranchée 110.

La LED 100 de la figure 1 comprend une métallisation de contact d'anode 107 disposée sur et en contact avec la face supérieure de la couche 105, dans la partie active de la LED. A titre d'exemple, la métallisation 107 s'étend sur toute la surface de la couche 105 dans la partie active de la LED. La métallisation 107 est de préférence en un métal réfléchissant dans la gamme de longueurs d'onde de la LED, par exemple en aluminium. Dans cet exemple, la LED est destinée à émettre de la lumière par sa face inférieure (à travers la couche tampon 12 et le substrat de support 10).

Dans l'exemple de la figure 1, la LED 100 comprend en outre une couche de masque dur 109 en un matériau isolant, par exemple en oxyde de silicium, revêtant la face supérieure de la métallisation 107 dans la partie active de la LED. La couche 109 est utilisée comme couche de masquage protégeant la partie active de la LED lors de la réalisation de la tranchée périphérique 110. Dans l'exemple représenté, la couche de masquage 109 n'est pas retirée à l'issue de la gravure de la tranchée 110 et subsiste donc dans la LED finale.

La LED 100 de la figure 1 comprend de plus une métallisation de contact de cathode (non visible sur la figure) en contact avec la couche 101. A titre d'exemple, la métallisation de contact de cathode peut être disposée sur et en contact avec la face supérieure de la couche 101 au fond de la tranchée périphérique 110.

La LED 100 de la figure 1 comprend de plus, sur les parois latérales de la tranchée périphérique 110, une grille conductrice isolée revêtant les flancs de la partie active de la LED. Plus particulièrement, la grille conductrice isolée comprend une couche d'isolant de grille 111, par exemple en oxyde de silicium ou en alumine (Al₂O₃) , disposée sur et en contact avec les flancs latéraux des couches 101, 103 et 105 et de la métallisation 107, et une couche conductrice de grille 113, par exemple une couche métallique, disposée sur et en contact avec la face de la couche 111 opposée aux couches 101, 103, 105 et 107. La couche conductrice de grille 113 est isolée électriquement de la métallisation de contact d'anode 107 et de la métallisation de contact de cathode (non représentée) de la LED.

Dans l'exemple de la figure 1, les couches 111 et 113 s'étendent en outre sur les flancs de la couche de masque dur 109 revêtant la métallisation 107. De plus, dans cet exemple, les couches 111 et 113 s'étendent en outre sur une partie périphérique de la face supérieure de la couche 109 dans la partie active de la LED, et sur la face supérieure de la couche 101 dans la partie périphérique de la LED (au fond de la tranchée 110).

Dans cet exemple, la LED 100 comprend en outre, en vis-à-vis de sa partie active, une métallisation de connexion 115 disposée dans une ouverture traversant les couches 113, 111 et 109, la métallisation 115 étant en contact, par sa face inférieure, avec la face supérieure de la métallisation de contact d'anode 107. La métallisation 115 est isolée de la couche conductrice de grille 113 par un espaceur isolant 117, et permet la reprise d'un contact électrique sur la métallisation 107.

Pour émettre de la lumière, une tension positive est appliquée entre la métallisation de contact d'anode 107 et la métallisation de contact de cathode (non représentée) de la LED. De plus, dans cet exemple, un potentiel négatif par rapport au potentiel de la métallisation de contact de cathode est appliqué sur la grille 113. Il en résulte une accumulation de trous au niveau des flancs de la couche de type P 105 de la LED, conduisant à la formation d'un canal de trous au voisinage des flancs de la couche P. Ceci permet de faciliter l'injection de trous dans la couche émissive 103 de la LED, et ainsi d'améliorer le rendement de conversion lumineux de la LED.

La fabrication de la LED 100 de la figure 1 peut comprendre les étapes successives suivantes :
- dépôt par épitaxie des couches successives 12, 101, 103 et 105 sur la face supérieure du substrat de support 10 ;
- dépôt d'une couche métallique, par exemple en aluminium, sur toute la surface supérieure de l'empilement, en vue de la formation de la métallisation de contact d'anode 107 de la LED ;
- formation du masque dur 109 sur la face supérieure de la couche métallique, en vis-à-vis de la partie active de la LED ;
- formation des tranchées 110 par gravure des couches 107, 105, 103, et, éventuellement, 101, de façon à délimiter latéralement la partie active de la LED ; et
- dépôt de la couche d'isolant de grille 111 puis de la couche conductrice de grille 113 sur toute la surface supérieure de la structure, c'est-à-dire au fond et sur les parois latérales de la tranchée 110 dans la partie périphérique de la LED, et sur la face supérieure de la couche 109 dans la partie active de la LED.

La couche d'isolant de grille 111 est de préférence déposée par une méthode de dépôt conforme, par exemple par dépôt en couches monoatomiques successives ou dépôt ALD (de l'anglais "Atomic Layer Déposition"). A titre d'exemple, la couche d'isolant de grille 111 est choisie pour résister à un champ électrique d'au moins 10 MV/cm. A titre d'exemple, la couche 111 est en alumine (Al₂O₃). A titre d'exemple, l'épaisseur de la couche 111 est comprise entre 2 et 100 nm.

Une étape de retrait localisé des couches 113, 111 et 109 en vis-à-vis d'au moins une partie de la métallisation de contact d'anode 107 peut en outre être prévue pour permettre la reprise d'un contact électrique sur la métallisation 107, par l'intermédiaire de la métallisation de connexion 115.

Dans cet exemple, la réalisation de la métallisation de contact de cathode de la LED n'a pas été détaillée. A titre d'exemple, un retrait localisé des couches 111 et 113 au fond de la tranchée 110 peut être prévu pour permettre la reprise d'un contact électrique sur la face supérieure de la couche de cathode 101, via une métallisation non représentée. A titre de variante, la métallisation de contact de cathode peut être réalisée avant le dépôt des couches 111 et 113.

En pratique, une pluralité de LED identiques ou similaires peuvent être formées simultanément dans et sur l'empilement actif de LED formé par les couches 101, 103 et 105, par exemple en vue de former un micro-écran émissif à LED.

La gravure des couches semiconductrices 105, 103 et éventuellement 101 pour former la tranchée 110 est une gravure sèche, par exemple une gravure plasma. Un problème qui se pose est que, à l'issue de cette gravure, les flancs des couches semiconductrices 105, 103, et, le cas échant, 101 de la partie active de la LED peuvent être superficiellement endommagés. Ceci peut conduire à dégrader significativement la conductivité du canal de trou induit par l'application d'un potentiel négatif sur la grille conductrice 113.

Pour pallier cet inconvénient, une possibilité est de prévoir, après l'étape de gravure sèche, un nettoyage des flancs des couches semiconductrices 101, 103 et 105, au moyen d'une solution de gravure chimique par voie humide, par exemple une solution à base d'hydroxyde de potassium (KOH) ou une solution à base d'hydroxyde de tétraméthylammonium (TMAH) ou une solution à base d'hydroxyde de tétraéthylammonium (TEAH) ou toute autre solution apte à attaquer le ou les composés III-N constitutifs des couches 101, 103 et 105.

Toutefois, ce nettoyage chimique peut conduire à endommager les flancs de la métallisation de contact d'anode 107 de la LED, ce qui peut notamment conduire à réduire la surface de contact entre la métallisation 107 et la couche d'anode 105, et donc diminuer l'efficacité de la LED.

La figure 2 est une vue en coupe schématique et partielle illustrant un autre exemple d'un dispositif optoélectronique 200 à jonction PN muni d'une grille conductrice isolée.

Le dispositif 200 de la figure 2 est une diode électroluminescente (LED), qui ne fait pas partie de l'invention revendiquée, et qui diffère de la LED 100 de la figure 1 principalement en ce que, dans la LED 200, un espaceur périphérique 201 en un matériau isolant, par exemple de l'oxyde de silicium, revêt les flancs de la métallisation de contact d'anode 107, séparant les flancs de la métallisation de contact d'anode 107 de la couche d'isolant de grille 111 et de la grille conductrice 113.

La fabrication de la LED 200 de la figure 2 peut comprendre les étapes successives suivantes :
- dépôt par épitaxie des couches successives 12, 101, 103 et 105 sur la face supérieure du substrat de support 10 ;
- dépôt d'une couche métallique, par exemple en aluminium, sur toute la surface supérieure de l'empilement, en vue de la formation de la métallisation de contact d'anode 107 de la LED ;
- formation du masque dur 109 sur la face supérieure de la couche métallique, en vis-à-vis de la partie active de la LED ;
- formation partielle des tranchées 110 par gravure à partir de la face supérieure de la couche métallique, jusqu'à la face supérieure de la couche semiconductrice 105, de façon à délimiter latéralement la métallisation de contact d'anode 107 de la LED ;
- formation d'un espaceur isolant 201, par exemple en oxyde de silicium, en contact avec les flancs de la métallisation de contact d'anode 107 sur toute la périphérie de la métallisation 107 - dans cet exemple, l'espaceur 201 s'étend également sur et en contact avec les flancs de la couche de masque dur 109 ;
- prolongement des tranchées 110 par gravure sèche, par exemple par gravure plasma, au moins jusqu'à la face supérieure de la couche 101, de façon à délimiter la partie active de la LED - lors de cette étape, les portions des couches 105, 103 et, le cas échéant, 101, situées sous l'espaceur 201, ne sont pas gravées ;
- nettoyage chimique des surfaces des couches semiconductrices 101, 103 et 105 exposées à l'issue de l'étape de gravure sèche, par exemple au moyen d'une solution à base de KOH, de TMAH ou de TEAH, ou au moyen de toute autre solution apte à attaquer le ou les composés III-N constitutifs des couches 101, 103 et 105 ; et
- dépôt de la couche d'isolant de grille 111 puis de la couche conductrice de grille 113 sur toute la surface supérieure de la structure, c'est-à-dire au fond et sur les parois latérales de la tranchée 110 et sur la face supérieure de la métallisation de contact 107, dans la partie active de la LED.

Comme dans l'exemple de la figure 1, la couche d'isolant de grille 111 est de préférence déposée par une méthode de dépôt conforme, par exemple par dépôt ALD. A titre d'exemple, la couche d'isolant de grille 111 est choisie pour résister à un champ électrique d'au moins 10 MV/cm. A titre d'exemple, la couche 111 est en alumine (Al₂O₃) . A titre d'exemple, l'épaisseur de la couche 111 est comprise entre 2 et 100 nm.

De façon similaire à ce qui a été décrit en relation avec la figure 1, une étape de retrait localisé des couches 113, 111 et 109 en vis-à-vis d'au moins une partie de la métallisation de contact d'anode 107 peut être prévue pour permettre la reprise d'un contact électrique sur la métallisation 107, par l'intermédiaire d'une métallisation de connexion 115.

De plus, la métallisation de contact de cathode de la LED (non visible sur la figure 2) peut être réalisée de façon similaire à ce qui a été décrit en relation avec la figure 1.

Dans l'exemple de la figure 2, l'étape de nettoyage chimique des surfaces exposées des couches semiconductrices 105, 103 et 101 à l'intérieur de la tranchée 110 permet de retirer le film superficiel de matériau semiconducteur éventuellement endommagé pendant l'étape de gravure sèche de la tranchée 110. L'espaceur 201 permet de protéger les flancs de la métallisation de contact d'anode 107 pendant l'étape de nettoyage chimique. De préférence, le temps de gravure est adapté de façon que l'épaisseur de matériau semiconducteur retirée sur les flancs de la partie active de la LED soit inférieure à l'épaisseur de l'espaceur 201, afin de ne pas atteindre la couche 107.

Ainsi, on obtient une interface de bonne qualité entre la couche d'isolant de grille 111 et les flancs des couches semiconductrices de la partie active de la LED, tout en préservant l'intégrité des flancs de la métallisation de contact d'anode 107 de la LED.

Toutefois, un inconvénient de la LED de la figure 2 est que l'espaceur 201 éloigne la métallisation de contact d'anode 107 de la LED de la grille conductrice 113. Ceci rend plus difficile la formation, dans la couche d'anode 105, d'un canal de conduction de trous allant de la métallisation 107 à la couche émissive 103.

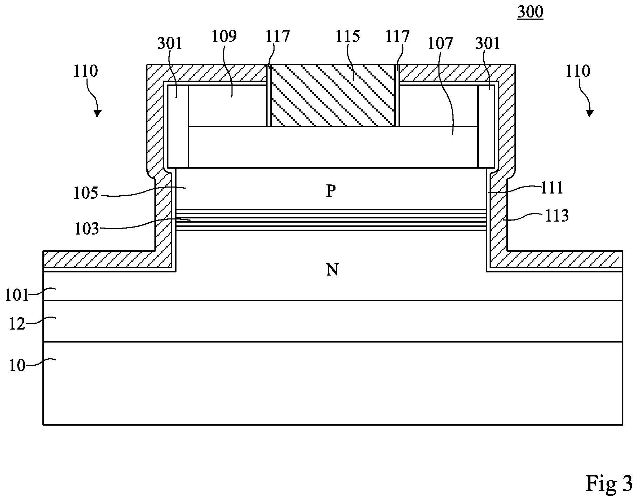

La figure 3 est une vue en coupe schématique et partielle illustrant un exemple d'un dispositif optoélectronique 300 à jonction PN muni d'une grille conductrice isolée selon un mode de réalisation.

Le dispositif 300 de la figure 3 est une diode électroluminescente (LED) qui diffère de la LED 200 de la figure 2 principalement en ce que, dans la LED 300, l'espaceur isolant 201 de la LED 200 est remplacé par un espaceur 301 en un matériau conducteur, par exemple en métal. L'espaceur 301 forme une couronne en contact d'une part, par sa face intérieure, avec les flancs de la métallisation 107, par exemple sur toute la périphérie de la métallisation 107, et d'autre part, par sa face extérieure avec la couche d'isolant de grille 111 de la LED.

En fonctionnement, l'espaceur 301 est au même potentiel que la métallisation de contact d'anode 107, ce qui favorise la formation d'un canal de conduction de trous vers la couche émissive 103 par rapport à une structure du type décrit en relation avec la figure 2 dans laquelle l'espaceur est en un matériau isolant.

La fabrication de la LED 300 de la figure 3 comprend les étapes successives suivantes :
- dépôt par épitaxie des couches successives 12, 101, 103 et 105 sur la face supérieure du substrat de support 10 ;
- dépôt d'une couche métallique, par exemple en aluminium, sur toute la surface supérieure de l'empilement, en vue de la formation de la métallisation de contact d'anode 107 de la LED ;
- formation du masque dur 109 sur la face supérieure de la couche métallique, en vis-à-vis de la partie active de la LED ;
- formation partielle des tranchées 110 par gravure à partir de la face supérieure de la couche métallique, jusqu'à la face supérieure de la couche semiconductrice 105, de façon à délimiter latéralement la métallisation de contact d'anode 107 de la LED ;
- formation d'un espaceur conducteur 301, par exemple en métal, en contact avec les flancs de la métallisation de contact d'anode 107, par exemple sur toute la périphérie de la métallisation 107 - dans cet exemple, l'espaceur 301 s'étend également sur et en contact avec les flancs de la couche de masque dur 109 ;
- prolongement des tranchées 110 par gravure sèche, par exemple par gravure plasma, au moins jusqu'à la face supérieure de la couche 101, de façon à délimiter la partie active de la LED - lors de cette étape, les portions des couches 105, 103 et, le cas échéant, 101, situées sous l'espaceur 301 ne sont pas gravées ;
- nettoyage chimique des surfaces des couches semiconductrices 101, 103 et 105 exposées à l'issue de l'étape de gravure sèche, par exemple au moyen d'une solution à base de KOH, de TMAH ou de TEAH, ou au moyen de toute autre solution apte à attaquer le ou les composés III-N constitutifs des couches 101, 103 et 105 ; et
- dépôt de la couche d'isolant de grille 111 puis de la couche conductrice de grille 113 sur toute la surface supérieure de la structure, c'est-à-dire au fond et sur les parois latérales de la tranchée 110 et sur la face supérieure de la métallisation de contact 107, dans la partie active de la LED.

Comme dans l'exemple des figures 1 et 2, la couche d'isolant de grille 111 est de préférence déposée par une méthode de dépôt conforme, par exemple par dépôt ALD. A titre d'exemple, la couche d'isolant de grille 111 est choisie pour résister à un champ électrique d'au moins 10 MV/cm. A titre d'exemple, la couche 111 est en alumine (Al₂O₃) . A titre d'exemple, l'épaisseur de la couche 111 est comprise entre 2 et 100 nm.

De façon similaire à ce qui a été décrit en relation avec les figures 1 et 2, une étape de retrait localisé des couches 113, 111 et 109 en vis-à-vis d'au moins une partie de la métallisation de contact d'anode 107 peut être prévue pour permettre la reprise d'un contact électrique sur la métallisation 107, par exemple par l'intermédiaire d'une métallisation de connexion 115.

De plus, la métallisation de contact de cathode de la LED (non visible sur la figure 3) peut être réalisée de façon similaire à ce qui a été décrit en relation avec la figure 1.

Dans l'exemple de la figure 3, la formation de l'espaceur 301 comprend une étape de dépôt non localisé (pleine plaque) d'un matériau conducteur, par exemple un métal, sur toute la surface supérieure de la structure obtenue à l'issue de l'étape de gravure partielle de la tranchée 110. La couche conductrice s'étend ainsi de façon continue sur sensiblement toute la surface supérieure de la structure, c'est-à-dire sur la face supérieure de la couche de masque dur 109, sur les flancs de la couche de masque dur 109 et de la métallisation 107, ainsi que sur la face supérieure de la couche semiconductrice 105 au fond de la tranchée partielle 110. La couche conductrice peut être déposée par une méthode de dépôt conforme de façon à présenter une épaisseur sensiblement uniforme sur toute la surface de la structure. L'épaisseur de la couche conductrice est par exemple comprise entre 10 nm et 1 µm. Après le dépôt de la couche conductrice, une étape de gravure directionnelle (anisotrope) verticale non localisée (pleine plaque) de la couche conductrice peut être prévue de façon à retirer les portions horizontales et conserver uniquement les portions verticales de la couche conductrice. La gravure mise en oeuvre lors de cette étape est par exemple une gravure de type IBE (de l'anglais Ion Beam Etching - gravure par faisceau d'ions) ou une gravure de type ICP-RIE (de l'anglais "Inductively Coupled Plasma Reactive Ion Etch" - gravure plasma ionique réactive à plasma à couplage inductif). A l'issue de cette étape, seule la portion verticale de la couche conductrice, revêtant les flancs de la métallisation de contact d'anode 107 et de la couche de masque dur 109 est conservée, formant l'espaceur métallique 301.

L'étape de nettoyage chimique des surfaces exposées des couches semiconductrices 105, 103 et 101 à l'intérieur de la tranchée 110 permet de retirer le film superficiel de matériau semiconducteur éventuellement endommagé pendant l'étape de gravure sèche de la tranchée 110. L'espaceur 301 permet de protéger les flancs de la métallisation de contact d'anode 107 pendant l'étape de nettoyage chimique. De préférence, le temps de gravure est adapté de façon que l'épaisseur de matériau semiconducteur retirée sur les flancs de la partie active de la LED soit inférieure à l'épaisseur de l'espaceur 301, afin de ne pas atteindre la couche 107.

L'espaceur 301 peut être en un métal différent de celui de la métallisation contact d'anode 107. A titre d'exemple, l'espaceur 301 est un métal du groupe comprenant le platine, le nickel et le tungstène, ces métaux présentant l'avantage de ne pas ou peu être attaqués par les solutions de nettoyage chimique à base de KOH, de TMAH ou de TEAH. De préférence, l'espaceur 301 est en platine, qui présente l'avantage supplémentaire de former un bon contact électrique avec la couche 105.

A titre de variante, le matériau de la couche de masque dur 109 peut être un matériau conducteur. Dans ce cas, la métallisation de connexion 115 n'a pas besoin de traverser le masque dur 109. A titre d'exemple, la métallisation de connexion 115 traverse uniquement les couches 113 et 111 et est en contact, par sa face inférieure, avec la face supérieure de la couche 109, la face inférieure de la couche 109 étant en contact avec la face supérieure de la métallisation 107. A titre d'exemple, le masque dur 109 est en le même matériau conducteur que l'espaceur 301.

Divers modes de réalisation et variantes ont été décrits. L'homme de l'art comprendra que certaines caractéristiques de ces divers modes de réalisation et variantes pourraient être combinées, et d'autres variantes apparaîtront à l'homme de l'art. En particulier, les modes de réalisation décrits ne se limitent pas aux exemples de matériaux et de dimensions mentionnés dans la présente description. Plus particulièrement, les couches semiconductrices 101, 103 et/ou 105 peuvent être en des matériaux semiconducteurs autres que des composés III-N.

De plus, bien que l'on ait décrit ci-dessus uniquement des exemples de dispositifs photoémetteurs de type LED, les modes de réalisations décrits peuvent également s'appliquer à des dispositifs photodétecteurs à jonction PN, par exemple des photodiodes.

En outre, les modes de réalisation décrits ne se limitent pas à l'exemple particulier décrit en relation avec la figure 3 dans lequel la grille conductrice isolée formée par l'empilement des couches 111 et 113 s'étend sur les flancs des couches semiconductrice 103 et 101 du dispositif. A titre de variante, la grille conductrice isolée peut revêtir uniquement les flancs latéraux de l'espaceur 301 et des couches semiconductrices 105 et 103, voire uniquement les flancs latéraux de l'espaceur 301 et de la couche semiconductrice 105.

De plus, on a décrit ci-dessus des exemples de réalisation dans lesquels la grille conductrice 113 est isolée électriquement non seulement de la métallisation de contact d'anode 115, mais également de la métallisation de contact de cathode (non représentée). A titre de variante, la grille conductrice 113 peut être isolée électriquement de la métallisation de contact d'anode 115 mais connectée électriquement à la métallisation de contact de cathode. On peut alors obtenir un effet de champ similaire à ce qui a été décrit ci-dessus, notamment pour des tensions de fonctionnement relativement élevées, par exemple au-delà de 5 volts.

## Revendications

1. Dispositif optoélectronique (300) comportant :
- un empilement vertical d'une première couche (101) semiconductrice dopée d'un premier type de conductivité, d'une deuxième couche (105) semiconductrice dopée du deuxième type de conductivité formant avec la première couche une jonction PN, et d'une troisième couche (107) conductrice disposée sur et en contact avec la face de la deuxième couche opposée à la première couche ;
- une tranchée périphérique (110) traversant les troisième (107) et deuxième (105) couches, ladite tranchée délimitant latéralement une portion de la troisième couche (107) et une portion de la deuxième couche (105) ;
- dans ladite tranchée (110), un espaceur conducteur (301) en contact avec un flanc latéral de ladite portion de la troisième couche (107) ; et
- dans ladite tranchée (110), une grille conductrice isolée (113, 111) comprenant une couche d'isolant de grille (111) s'étendant sur et en contact avec un flanc latéral de l'espaceur conducteur (301) et sur et en contact avec un flanc latéral de ladite portion de la deuxième couche, et une couche conductrice de grille (113) disposée sur et en contact avec la face de la couche d'isolant de grille (111) opposée à l'espaceur conducteur (301) et à ladite portion de la deuxième couche,
**caractérisé en ce que** l'espaceur conducteur (301) est constitué par une quatrième couche conductrice revêtant uniquement les parois latérales de ladite tranchée (110).

2. Dispositif (300) selon la revendication 1, dans lequel l'espaceur conducteur (301) est en un matériau différent de celui de la troisième couche (107).

3. Dispositif (300) selon la revendication 1 ou 2, dans lequel l'espaceur conducteur (301) est en métal.

4. Dispositif (300) selon la revendication 2, dans lequel l'espaceur conducteur (301) est en un métal du groupe comprenant le platine, le nickel et le tungstène.

5. Dispositif (300) selon l'une quelconque des revendications 1 à 4, dans lequel la troisième couche (107) est en aluminium ou en argent.

6. Dispositif (300) selon l'une quelconque des revendications 1 à 5, comprenant en outre une métallisation de connexion en contact avec la première couche (101) semiconductrice.

7. Dispositif (300) selon la revendication 6, dans lequel ladite métallisation de connexion est isolée électriquement de la grille conductrice (113, 111).

8. Dispositif (300) selon la revendication 6, dans lequel ladite métallisation de connexion est connectée électriquement à la grille conductrice isolée (113, 111).

9. Dispositif (300) selon l'une quelconque des revendications 1 à 8, comportant en outre une couche semiconductrice émissive (103) entre les première (101) et deuxième (105) couches semiconductrices, dans lequel la tranchée périphérique (110) traverse la couche semiconductrice émissive (103), ladite tranchée délimitant latéralement une portion de la couche semiconductrice émissive (103), et la grille conductrice isolée (113, 111) s'étendant contre un flanc latéral de ladite portion de la couche semiconductrice émissive (103).

10. Dispositif (300) selon l'une quelconque des revendications 1 à 9, dans lequel chacune des première (101) et deuxième (105) couches semiconductrices est en un composé III-N.

11. Procédé de fabrication d'un dispositif optoélectronique (300) selon l'une quelconque des revendications 1 à 10, comprenant les étapes successives suivantes :
a) prévoir un empilement comportant les première (101), deuxième (105) et troisième (107) couches ;
b) former une tranchée périphérique (110) traversant la troisième couche (107) et s'interrompant sur la deuxième couche (105), ladite tranchée délimitant latéralement ladite portion de la troisième couche (107) ;
c) former dans ladite tranchée (110) un espaceur conducteur (301) en contact avec les flancs de ladite portion de la troisième couche (107) ;
d) prolonger ladite tranchée (110) à travers la deuxième couche (105), ladite tranchée (110) prolongée délimitant latéralement ladite portion de la deuxième couche (105) ; et
e) former dans ladite tranchée (110) la grille conductrice isolée (113, 111),
**caractérisé en ce que** l'étape c) comprend :
- une étape de dépôt d'une quatrième couche conductrice sur la face supérieure de la troisième couche (107) et sur les parois latérales et au fond de ladite tranchée (110) ; puis
- une étape de gravure anisotrope verticale de la quatrième couche conductrice, à l'issue de laquelle seules sont conservées les portions verticales de la quatrième couche conductrice revêtant les parois latérales de ladite tranchée (110).

12. Procédé selon la revendication 11, comprenant en outre, après l'étape d) et avant l'étape e), une étape de nettoyage chimique des surfaces exposées de la première couche (105) à l'intérieur de la tranchée (110).

13. Procédé selon la revendication 12, dans lequel l'étape de nettoyage chimique est réalisée au moyen d'une solution à base d'hydroxyde de potassium ou d'une solution à base d'hydroxyde de tétraméthylammonium ou d'une solution à base d'hydroxyde de tétraéthylammonium.

## Patentansprüche

1. Optoelektronische Vorrichtung (300), die Folgendes aufweist:
- einen vertikalen Stapel aus einer ersten dotierten Halbleiterschicht (101) eines ersten Leitfähigkeitstyps, einer zweiten dotierten Halbleiterschicht (105) des zweiten Leitfähigkeitstyps, die mit der ersten Schicht einen PN-Übergang bildet, und einer dritten leitenden Schicht (107), die auf der der ersten Schicht gegenüberliegenden Oberfläche der zweiten Schicht angeordnet ist und mit dieser in Kontakt steht;
- einen Randgraben (110), der die dritte (107) und die zweite (105) Schicht durchquert, wobei der Graben einen Abschnitt der dritten Schicht (107) und einen Abschnitt der zweiten Schicht (105) seitlich begrenzt;
- in dem Graben (110) einen leitenden Abstandshalter (301) in Kontakt mit einer seitlichen Seite des Abschnitts der dritten Schicht (107); und
- in dem Graben (110) ein isoliertes leitfähiges Gate (113, 111) aufweisend eine Gate-Isolatorschicht (111), die sich auf der Oberseite und in Kontakt mit einer seitlichen Seite des leitfähigen Abstandshalters (301) und auf der Oberseite und in Kontakt mit einer seitlichen Seite des Abschnitts der zweiten Schicht erstreckt, und eine leitende Gate-Schicht (113), die auf der Oberfläche und in Kontakt mit der Gate-Isolator-Schicht (111) gegenüber dem leitenden Abstandshalter (301) und dem Abschnitt der zweiten Schicht angeordnet ist,
**dadurch gekennzeichnet, dass** der leitfähige Abstandshalter (301) aus einer vierten leitfähigen Schicht hergestellt ist, die nur die Seitenwände des Grabens (110) beschichtet.

2. Vorrichtung (300) nach Anspruch 1, wobei der leitfähige Abstandshalter (301) aus einem Material hergestellt ist, das sich von dem der dritten Schicht (107) unterscheidet.

3. Vorrichtung (300) nach Anspruch 1 oder 2, wobei der leitfähige Abstandshalter (301) aus Metall hergestellt ist.

4. Vorrichtung (300) nach Anspruch 2, wobei der leitfähige Abstandshalter (301) aus einem Metall aus der Gruppe Platin, Nickel und Wolfram hergestellt ist.

5. Vorrichtung (300) gemäß einem der Ansprüche 1 bis 4, wobei die dritte Schicht (107) aus Aluminium oder Silber hergestellt ist.

6. Vorrichtung (300) gemäß einem der Ansprüche 1 bis 5, die ferner eine Verbindungsmetallisierung in Kontakt mit der ersten Halbleiterschicht (101) aufweist.

7. Vorrichtung (300) gemäß Anspruch 6, wobei die Verbindungsmetallisierung elektrisch von dem leitfähigen Gate (113, 111) isoliert ist.

8. Vorrichtung (300) gemäß Anspruch 6, wobei die Verbindungsmetallisierung elektrisch mit dem isolierten leitfähigen Gate (113, 111) verbunden ist.

9. Vorrichtung (300) gemäß einem der Ansprüche 1 bis 8, die ferner aufweisend eine emittierende Halbleiterschicht (103) zwischen der ersten (101) und der zweiten (105) Halbleiterschicht, wobei der Randgraben (110) die emittierende Halbleiterschicht (103) durchquert, wobei der Graben einen Abschnitt der emittierenden Halbleiterschicht (103) seitlich begrenzt und das isolierte leitende Gate (113, 111) sich an einer seitliche Seite des Abschnitts der emittierenden Halbleiterschicht (103) erstreckt.

10. Vorrichtung (300) gemäß einem der Ansprüche 1 bis 9, wobei jede der ersten (101) und zweiten (105) Halbleiterschichten aus einer III-N-Verbindung besteht.

11. Verfahren zur Herstellung einer optoelektronischen Vorrichtung (300) gemäß einem der Ansprüche 1 bis 10, das die folgenden aufeinanderfolgenden Schritte aufweist:
a) Bereitstellen eines Stapels, der die erste (101), zweite (105) und dritte (107) Schicht aufweist;
b) Ausbilden eines Randgrabens (110), der die dritte Schicht (107) durchquert und auf der zweiten Schicht (105) endet, wobei der Graben den Abschnitt der dritten Schicht (107) seitlich begrenzt;
c) Ausbilden eines leitenden Abstandshalters (301) in dem Graben (110) in Kontakt mit den Seiten des Abschnitts der dritten Schicht (107);
d) Fortsetzen des Grabens (110) durch die zweite Schicht (105), wobei der fortgesetzte Graben (110) den Abschnitt der zweiten Schicht (105) seitlich begrenzt; und
e) Ausbilden des isolierten leitenden Gates (113, 111) in dem Graben (110),
**dadurch gekennzeichnet, dass** Schritt c) Folgendes aufweist:
- einen Schritt des Abscheidens einer vierten leitenden Schicht auf der oberen Oberfläche der dritten Schicht (107) und auf den Seitenwänden und dem Boden des Grabens (110);
gefolgt von
einem Schritt des vertikalen anisotropen Ätzens der vierten leitenden Schicht, an dessen Ende nur die vertikalen Abschnitte der vierten leitenden Schicht, die die Seitenwände des Grabens (110) bedecken, erhalten bleiben.

12. Verfahren nach Anspruch 11, das ferner nach Schritt d) und vor Schritt e) einen Schritt des chemischen Reinigens der freiliegenden Oberflächen der ersten Schicht (105) innerhalb des Grabens (110) aufweist.

13. Verfahren nach Anspruch 12, wobei der Schritt der chemischen Reinigung mittels einer Lösung auf der Basis von Kaliumhydroxid oder einer Lösung auf der Basis von Tetramethylammoniumhydroxid oder einer Lösung auf der Basis von Tetraethylammoniumhydroxid durchgeführt wird.

## Claims

1. Optoelectronic device (300) comprising:
- a vertical stack of a first doped semiconductor layer (101) of a first conductivity type, of a second doped semiconductor layer (105) of the second conductivity type forming with the first layer a PN junction, and of a third conductive layer (107) arranged on top of and in contact with the surface of the second layer opposite to the first layer;
- a peripheral trench (110) crossing the third (107) and second (105) layers, said trench laterally delimiting a portion of the third layer (107) and a portion of the second layer (105);
- in said trench (110), a conductive spacer (301) in contact with a lateral side of said portion of the third layer (107); and
- in said trench (110), an insulated conductive gate (113, 111) comprising a gate insulator layer (111) extending on top of and in contact with a lateral side of the conductive spacer (301) and on top of and in contact with a lateral side of said portion of the second layer, and a conductive gate layer (113) arranged on top of and in contact with the surface of the gate insulator layer (111) opposite to the conductive spacer (301) and to said portion of the second layer,
**characterized in that** the conductive spacer (301) is made of a fourth conductive layer coating only the side walls of said trench (110).

2. Device (300) according to claim 1, wherein the conductive spacer (301) is a material different from that of the third layer (107).

3. Device (300) according to claim 1 or 2, wherein the conductive spacer (301) is made of metal.

4. Device (300) according to claim 2, wherein the conductive spacer (301) is made of a metal from the group comprising platinum, nickel, and tungsten.

5. Device (300) according to any of claims 1 to 4, wherein the third layer (107) is made of aluminum or of silver.

6. Device (300) according to any of claims 1 to 5, further comprising a connection metallization in contact with the first semiconductor layer (101).

7. Device (300) according to claim 6, wherein said connection metallization is electrically insulated from the conductive gate (113, 111).

8. Device (300) according to claim 6, wherein said connection metallization is electrically connected to the insulated conductive gate (113, 111).

9. Device (300) according to any of claims 1 to 8, further comprising an emissive semiconductor layer (103) between the first (101) and second (105) semiconductor layers, wherein the peripheral trench (110) crosses the emissive semiconductor layer (103), said trench laterally delimiting a portion of the emissive semiconductor layer (103), and the insulated conductive gate (113, 111) extending against a lateral side of said portion of the emissive semiconductor layer (103).

10. Device (300) according to any of claims 1 to 9, wherein each of the first (101) and second (105) semiconductor layers is made of a III-N compound.

11. Method of manufacturing an optoelectronic device (300) according to any of claims 1 to 10, comprising the successive steps of:
a) providing a stack comprising the first (101), second (105), and third (107) layers;
b) forming a peripheral trench (110) crossing the third layer (107) and stopping on the second layer (105), said trench laterally delimiting said portion of the third layer (107);
c) forming in said trench (110) a conductive spacer (301) in contact with the sides of said portion of the third layer (107);
d) continuing said trench (110) through the second layer (105), said continued trench (110) laterally delimiting said portion of the second layer (105); and
e) forming in said trench (110) the insulated conductive gate (113, 111),
**characterized in that** step c) comprises:
- a step of depositing a fourth conductive layer on the upper surface of the third layer (107) and on the side walls and at the bottom of said trench (110) ;
followed by
- a step of vertical anisotropic etching of the fourth conductive layer, at the end of which only the vertical portions of the fourth conductive layer coating the side walls of said trench (110) are kept.

12. Method according to claim 11, further comprising after step d) and before step e), a step of chemical cleaning of the exposed surfaces of the first layer (105) inside of the trench (110).

13. Method according to claim 12, wherein the step of chemical cleaning is carried out by means of a solution based on potassium hydroxide or of a solution based on tetramethylammonium hydroxide, or of a solution based on tetraethylammonium hydroxide.
